**Europäisches Patentamt**

**European Patent Office**

**Office européen des brevets**

(11) Publication number : **0 481 097 B1**

# EUROPEAN PATENT SPECIFICATION

(45) Date of publication of patent specification :
**14.06.95 Bulletin 95/24**

(51) Int. Cl.⁶ : **G06F 11/26**

(21) Application number : **90117819.4**

(22) Date of filing : **15.09.90**

(54) Method and apparatus for testing a VLSI device.

(43) Date of publication of application :
**22.04.92 Bulletin 92/17**

(45) Publication of the grant of the patent :
**14.06.95 Bulletin 95/24**

(84) Designated Contracting States :
**DE FR GB NL SE**

(56) References cited :
**EP-A- 0 108 256
US-A- 4 519 078
INTERNATIONAL SYMPOSIUM ON CIRCUITS
AND SYSTEMS, Kyoto, 5th - 7th June
1985,PROCEEDINGS, vol. 2, pages 663-666; M.
KAWAI et al.: "Automatic test pat-
terngenerator for large combiational circuits"
IBM TECHNICAL DISCLOSURE BULLETIN,
vol. 28, no. 10, March 1986, pages 4669-4675,
New York, US; "Chip-level self-testing circuit
for high density circuits"**

(73) Proprietor : **International Business Machines
Corporation
Old Orchard Road
Armonk, N.Y. 10504 (US)**

(72) Inventor : **Diebold, Ulrich, Dipl.-Ing.
Gänsbergring 74
D-7033 Herrenberg (DE)**
Inventor : **Riegler, Joachim, Dipl.-Ing.
Weingartenstrasse 9
D-7268 Gechingen (DE)**
Inventor : **Rost, Peter, Dipl.-Ing.
In den Lunkteilen
D-7260 Calw (DE)**
Inventor : **Schmidt, Manfred, Dipl.-Phys.
Dachenhäuserweg 37
D-7036 Schönaich (DE)**
Inventor : **Torreiter, Otto, Dipl.-Ing.
Fleinsbachstrasse 14
D-7022 Leinfelden-Echterdingen (DE)**
Inventor : **Verwegen, Peter, Dipl.-Ing.
Hohenstaufenstrasse 11
D-7030 Böblingen (DE)**
Inventor : **Weiland, Dawn
Im Heinental 21
D-7277 Wildberg 4 (DE)**
Inventor : **Wendel, Dieter, Dipl.-Ing.
Schöneberger Weg 14
D-7032 Sindelfingen (DE)**

(74) Representative : **Schäfer, Wolfgang, Dipl.-Ing.
et al
IBM Deutschland Informationssysteme GmbH
Patentwesen und Urheberrecht
D-70548 Stuttgart (DE)**

## Description

Field of the Invention

The present invention relates to methods of testing complex combinatorial and sequential logic circuits embodied in very large scale (VLSI) devices.

Description of the Prior Art

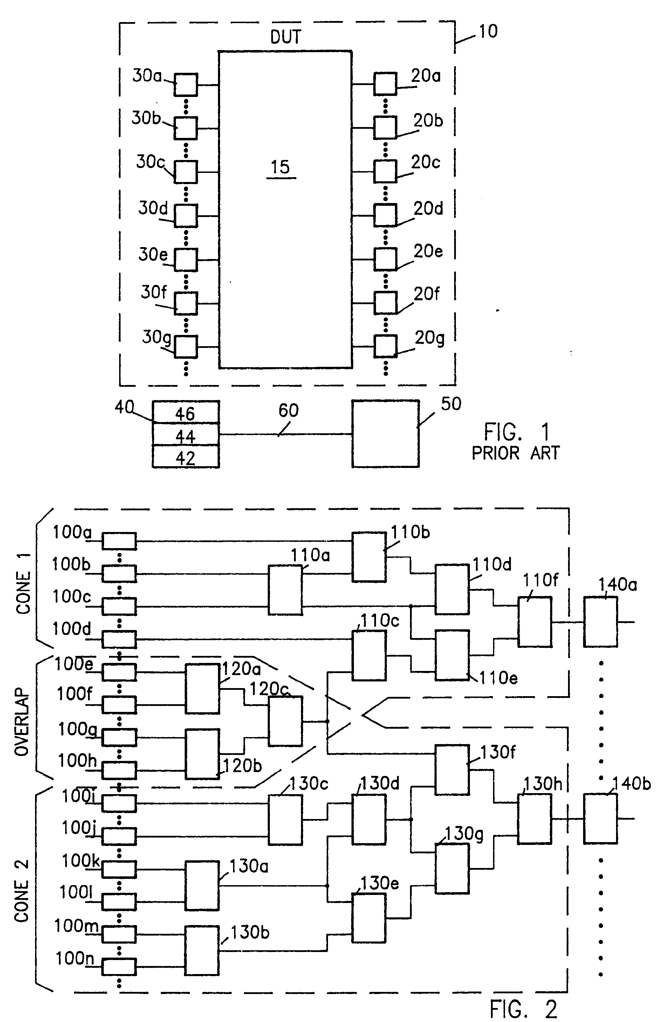

A fault occurring anywhere in a VLSI device can have its effect propagated through a number of gates before reaching a testable output of the device. Level sensitive scan design (LSSD) rules were devised to eliminate the complications in testing caused by this propagation. These rules, which were first published in an article entitled "A Logic Design Structure for LSI Testability" by E.B.Eichelberger and T.W.Williams in the Proceedings of the 14th Design Automation Conference, pp 462-468, impose a clocked structure on the logic circuit and require all the inputs and outputs of the logic circuits to be tied together to form a series of shift register scan paths. Fig. 1 shows a simplified tester built using these principles. Test unit 40 comprises a memory 42 to store the test pattern data, means 44 to simulate the response to the device under test and means 46 to supply the test pattern to the device under test. Test signals generated in unit 40 can therefore be applied to the device under test 10 using the device inputs 30 which are connected together to form a shift register. The input values are clocked through the shift register from the unit 40 using the connections shown as dotted lines on the Figure. After the test has been carried out by clocking the input values through the logic circuit 15 to be tested, the results appear at the output latches 20 which are also connected together to form a shift register. These output values are clocked out of the shift register into the comparator 50 which compares the obtained results with the simulated expected results and signals if there is a difference which would indicate the presence of a fault in the device under test 10.

The conventional method of generating logic test patterns is known as "Deterministic Stored-Pattern Testing" (DSPT). This involves using a deterministic algorithm to produce patterns which guarantee detection of specified logical faults which include, but are not limited to, stuck-at faults (i.e. faults in which a gate does not change its output in response to an input). Since each test pattern and its expected output response are stored as uncompressed vectors of signal values in the tester, large amounts of memory are required. It has been shown that as circuits become more complex, the number of possible stuck-at faults grows spectacularly as the number of gates in the circuit increase. The implication is that the number of possible test patterns required in order to test the circuit will also greatly increase. Hence the time required to test the circuit will be extended and memory requirements for storing all the test vectors will increase.

In order to reduce the time taken to generate the test patterns and the amount of memory required to store the patterns generated, so-called self-testing methods have been developed. These involve the use of pseudo-random pattern generators and response compression structures actually built into the device. Using such structures eliminates the computer time needed to generate the tests, whilst placing the elements required for testing directly to the device under test. This allows the application of large number of test patterns to the device, in a reasonable length of time. In two articles by Konemann, Mucha and Zwiehoff, "Built-in Logic Block Observation Techniques", 1979 IEEE Test Conference, pp37-40, Cherry Hill, NJ, October 1979 and "Built-in Test for Complex Digital Integrated Circuits", IEEE J.Solid-State Circ, vol SC-15, Nr 3, pp 315-319, June 1980, a modification to a shift register scan path - called the linear feedback shift register (LFSR) - was disclosed which could be used as an input signal generator and/or as an output data compression circuit.

A special self-test architecture is known as the STUMPS method, STUMPS being short for Self-Test using a MISR (multiple-input signature register) and a Parallel SRSG (shift register sequence generator). The basic principles of the method are well known and are described in a number of documents (e.g. EP-B-0 108 256 (IBM), US-A-4 519 078 (KOMONYTSJKY), US-A-713 605 (IYER et al), US-A-4 910 735 (YAMASHITA) or B.I.DERVISOLGLU "Scan-path architecture for pseudo random testing", IEEE Design and Test of Computers, Aug 1989, pp 32-48). It is found that, although STUMPS greatly reduces the amount of test data storage required, the quality of the tests is not high. An article by BASSET et al, "Low-cost testing of high density logic components", IEEE Design and Test of Computers, April 1990, pp 15-27, reports that one can only expect 90% fault coverage from STUMPS for a representative cross-section of chips. A combination of STUMPS and DPST would, it was concluded in the same article, increase the fault coverage. However, in order to determine the last 5 to 10% of faults (the so-called self-test escapes), experience has shown that one must generate 50-70% of the complete set of DPST test patterns.

Instead BASSETT et al favoured the use of the Weighted Random Pattern Test (WRPT) in which the design of the LFSR pattern generator is changed to produce a variable distribution of logical 1's and 0's for each test pattern input bit. This method selectively biases the input latches to a greater probability of 1 or 0 as required. Although fault coverage was much improved over the STUMPS method, substantially more complex hardware was needed to generate the pattern. An article by J. WAICUKAUSKI et al entitled "A method for generating weighted random test patterns" in the IBM Journal of Research and Development, vol 33, nr 2, March 1989, pp149-161, illustrated a number of ways in which WRPT patterns could be generated. The results obtained, however, suggested a fault coverage of 94-99% and thus deterministic pattern testing in the order of 50% of a full stored pattern test will still be required if one wishes to detect 99.9% of all faults.

None of the prior art discloses the use of an LSFR circuit to simultaneously produce input patterns and to compress output results.

## Summary of the Invention

It is an object of the invention to provide a method and a test pattern generator which can be used for testing the logic of a device. The means used for generating the test pattern does not require complex hardware nor large amounts of memory space to store the individual test pattern.

The test pattern generator can be directly incorporated onto the chip as well as being built into a stand-alone pattern tester. If incorporated onto a chip, the pattern generator can be further advantageously used for self-testing the defice.

The invention achieves these objects in accordance with the invention as defined in the claims.

## Brief Description of the Drawings

Fig. 1    shows the basic method of testing a device.
Fig. 2    is an illustrative example of a device under test, showing the logic gates connected between the input and output gates.
Fig. 3    shows a simple linear feedback shift register.
Fig. 4    shows an example of the generation of a seed.

## Detailed Description of the invention

The basic principle behind the invention can be understood by considering Fig. 2 which shows the internal logic of a typical device under test. The device consists of a number of internal logic gates 110a-f, 120a-c, 130a-h connected between input latches 100a-n and output latches 140a, 140b. It should be noted that this is merely an illustrative example, in practice a device under test would have many more input and output ports and many more logic gates connected between these ports. The input and output latches are separately connected together each to form a scan path represented by the dotted line in the Figure. If we now consider the pathways through the logic circuit of the device leading to the output latches 140 from the input latches 100, it can be seen that the values on the input latches 100a to 100h will affect the responses output on 140a. Similarly, the values on the input latches 100e to 100n will affect the results on output 140b. This means that two 'cones' can be defined, one of which runs from latches 100a to 100h to the output latch 140a and the other of which runs from input latches 100e to 100n to output latch 140b. These cones are marked on the Figure by the dashed lines. It will also be noted that the two cones overlap and that logic gates 120a-c are in both cones. This means that, if all of the logic gates in cone 1 have been tested and shown to have no faults, then in principle only those gates in cone 2 which do not also fall into cone 1 need to be tested in order to complete the test of the circuit (i.e. gates 130a-h). It should also be noted that, when testing cone 2, the values of the bits placed in latches 100e-h cannot be ignored since the output of tested logic gate 120c is connected to the input of untested logic gate 130f. However, the values of the bits placed in latches 100a-d are irrelevant to the test of the latches in cone 2. This means that three different types of bits can be defined which are placed in the latches 100a-n in order to test the logic gates: test-relevant bit positions (labelled R in table 1) which have to take specified values in order to test the cone; support-net bit positions (labelled A in table 1) which must have one of several specific values in order to test a cone and non-relevant bit positions (labelled X in table 1) whose value is not important in testing the cone. Table 1 shows the three different test procedures which are required in order to thoroughly test the logic network of Fig. 2.

Table 1

```
Net input to          cone 1      overlap       cone2
Latch 100             a b c d     e f g h     i j k l m n

Procedure A): Test nets common for cone 1 and cone 2

                      A A A A     R R R R     A A A A A A
                      .......     .......     ...........

Procedure B): Test nets of cone 1 and cone 2

                      R R R R     A A A A     R R R R R R
                      .......     .......     ...........

Procedure C): Test nets of cone 2

                      X X X X     A A A A     R R R R R R
                      .......     .......     ...........
```

Meaning of flags:

    o  R: Test-relevant bit positions - no alternative
    o  A: Support-net inputs - there are some alternatives
    o  X: Non-relevant bit positions - any value

In procedure A only the values contained in latches 100e-h are significant for testing the logic gates 120a-c contained in the overlap of the cones. During the testing procedures all possible combinations of 1's and 0's will be therefore placed on these latches 100e-h so that logic gates 120a-c are tested under all conditions. The bits stored in latches 100a-d and 100i-n are relevant only in that a meaningful output must be obtained at the output gates 140a and 140b. In procedure B, the gates in the individual cones are tested but not those in the overlap (i.e. gates 110a-f and 130a-h but not 120a-c). This means that the values of the bits placed in latches 100a-d and 100i-n are test-relevant and are cycled through all possible 1's and 0's combinations but those in latches 100e-h are only support-net inputs. Finally in Procedure C, only the logic gates 130a-h in cone 2 are tested. Again the bits in latches 100j-n are test-relevant and all possible combinations tested but the bits in latches 100f-h are support-net bits. However, in this case the values of the bits in latches 100a-d are irrelevant to the results of the test. It can therefore be seen that a large number of the test patterns which might be used for testing the logic gates in the device under test are redundant since they will generate no new information about faults in the circuit.

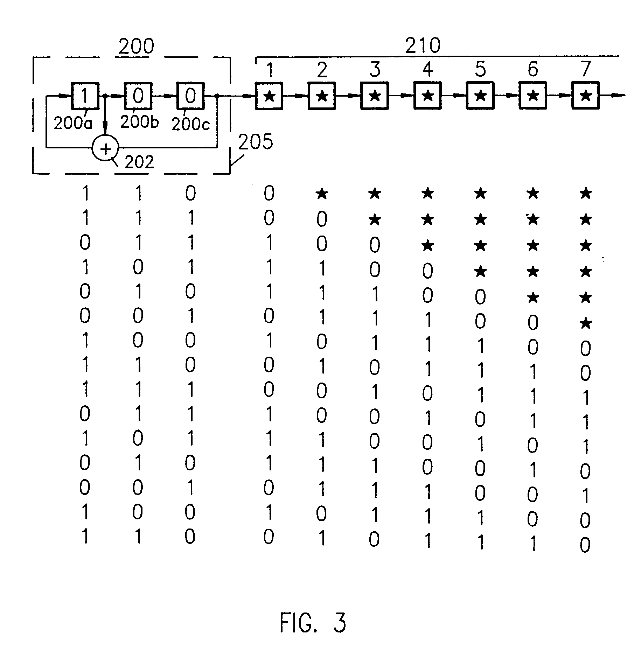

This idea of test-relevant bits can be used in conjunction with an LFSR to generate the test patterns for testing logic circuits. To see how this works, the method of generating patterns using an LFSR must first be reviewed. Fig. 3 shows a simplified LFSR 200, consisting of three latches 200a-c which produces an output 205 which can be clocked through to the scan path 210. The output of latch 200a is connected to both an XOR gate 202 and to the latch 200b. The output of latch 200c is connected both to the output 205 (and hence into the scan path 210) and also to the XOR gate 202. As the data is clocked through the LFSR (meaning that the value of 200a is placed in 200b, the value of 200b is placed in 200c and the value of 200c is transferred to the scan path), the new value of 200a is the result of the XOR operation on the previous value of 200a and the previous value of 200c. By choosing the appropriate initial values for the latches 200a-c in the LFSR 200, we can generate any possible combination of bits in the scan path. Fig. 3 shows how the initial value of 100 loaded into the LFSR 200 generates a series of 0's and 1's through the scan path 210.

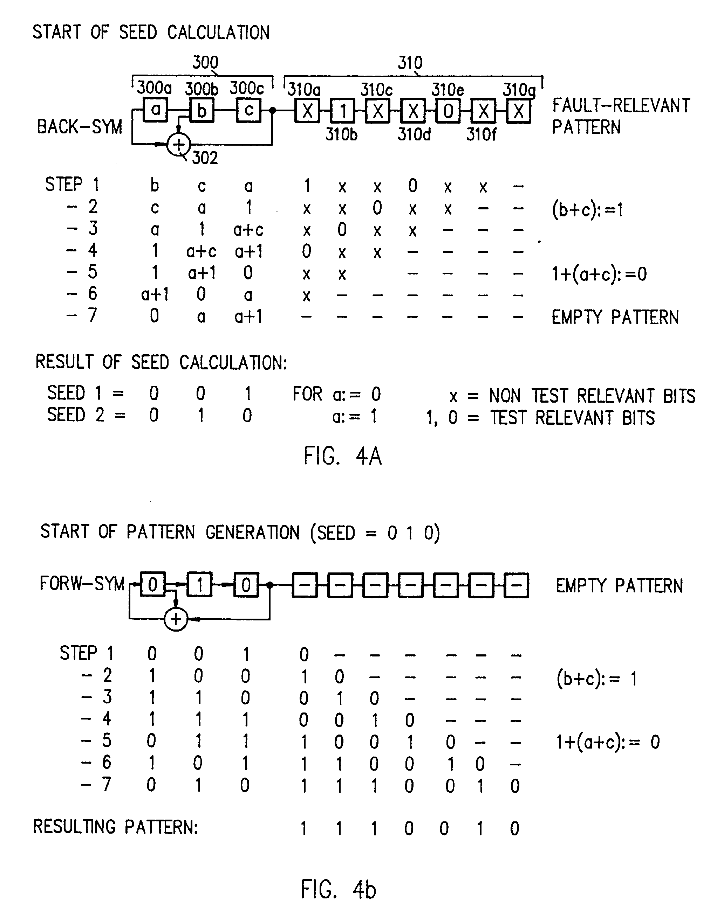

Now suppose that, instead of wishing to generate the pseudo-random test pattern as shown in Fig. 3, it is wished to generate a test pattern in which the bits stored in some of the latches 210 of the scan path are fixed. These bits represent the test relevant bit positions which were described above. Fig. 4a shows such a simulated scan path 310 in which the bits stored in latches 310c and 310e are set to be 1 and 0 respectively. The values of the bits stored in the other latches are not relevant. If, for the purposes of calculation, the values of the latches 300a-c of the LFSR 300 are arbitrarily set to a,b,c respectively, then we can 'clock back' the bits from the simulated scan path 310 into the LFSR 300 to obtain the initial 'seed' values for the LFSR 300 which can then be later used to generate the required test pattern with the test relevant bit positions having their required values. This clocking back procedure, which is carried out as a simulation and does not physically happen on the device under test 10, is illustrated by the various steps marked on Figure 4a.

In the first step the values stored in the latches 310b-g are all moved one latch to the left. So that the value previously stored in latch 310g is now stored in latch 310f, the value in 310f is now stored in 310e and so on. The value stored in latch 310a is ignored since it is a non-test relevant bit and thus latch 300c should take the result of the XOR operation performed by gate 302 on the values previously stored in latches 300a and 300b. In fact since, at this stage, no test relevant bit values have been clocked back from the scan path 310 into the LSFR 300, the value stored in latch 300c is purely arbitrary and it can be defined to be 'a' for simplicity. In the next step, the values stored in latches 310b-g are again moved one latch to the left. The value contained in latch 310a is now a test relevant bit and has the value 1. It is passed to latch 300c of the LSFR 300. The value that should be stored in latch 300c at this step is the result of the XOR operation performed in XOR gate 302, i.e. b+c. Thus we define the result of this XOR operation to be 1. In step 3 and step 4, the values stored in latch 310a are non relevant test bits and hence the value stored in latch 300c is not required to take any value and is therefore the result of the XOR operation of the values stored in latches 300a and 300b. In step 5, however, latch 300c is fed with the test relevant bit 0 from latch 310a. This defines the result of the XOR operation $1 + (a+c)$ to be 0 since latch 300a previously contained the value of 1 and latch 300b the value a+c. The simulation is continued for two more steps 6 and 7 even though the last two values are non relevant test bits. These steps are, however, necessary to ensure that the LSFR 300, when generating the complete test pattern, will produce bits with known values for all the latches 310a-g of the scan path 310 including the test relevant bits in the correct positions. The result of this operation can be seen from the final step 7, latch 310a must contain a 0, latch 300b will contain the value a and latch 300c will contain the value of a+1. Since a can take the value either 0 or 1, this means that two seeds (001 or 010) will generate the required test pattern. Fig. 4b demonstrates this for the seed 010.

Of course, in an actual test situation, the scan path would not consist of a mere seven latches of which only two values will be test relevant and thus have their values fixed. However, by increasing the size of the LFSR and by choosing suitable feedback paths for connection to XOR gates, it will be possible to generate any required pattern. Since only the seed for feeding the LFSR needs to be stored, the amount of memory required to implement this test pattern generating system is much smaller than would be required to directly store all the deterministic patterns.

The described test pattern generator can be either implemented directly on the chip to enable rapid self-testing of the device or it can be incorporated into a test apparatus to which the device is attached. In order to save more memory space and to speed up the testing process, the output results from testing can be additionally compressed using commonly known methods such as the multiple input signature register (MISR) described in the article by J.L.CARTER, "Improved signature test for VLSI Circuits", IBM Technical Disclosure Bulletin, vol 26, no 3A, August 1983, pp 965-967.

## Claims

1. Apparatus for testing a logic device (10) comprising
   means (40) for generating a test pattern for testing the device (10), wherein said device has device inputs (30) for loading the initial test pattern into the device (10); and device outputs (20) for outputting the results from the device (10);
   means (50) for comparing the output results from the device with the results expected and;
   means for signalling whether the said logic device has passed the test
   characterised in that
   said means (40) for generating a test pattern produces predetermined bit values on predetermined ones of said device inputs (30) and pseudo-random bit values on others of the said device inputs (30), with the input test data pattern being simultaneously generated by said means (40) for generating,
   said means (40) for generating a test pattern comprises a linear feedback shift register (300) and the said linear feedback shift register (300) is fed by pre-calculated initial values, i.e. seeds.

2. Apparatus for testing a logic device (10) according to claim 1 further characterised in that
   the said device inputs (30) are connected together to form a shift register scan path which is further connected to the said means (40) for generating a test pattern for testing the device (10).

3. Apparatus for testing a logic device (10) according to claim 1 further characterised in that
the said device outputs (20) are connected together to form a shift register scan path which is further
connected to the means (50) for comparing the output results from the device with the results expected.

4. Apparatus for testing a logic device (10) according to claim 3 further characterised in that
the means (50) for comparing the output results from the device with the results expected includes means
to compress the data before carrying out the comparison.

5. Apparatus for testing a logic device (10) according to claim 4 further characterised in that
the said device outputs (20) and the means (50) for comparing the output results from the device with
the results expected together form a multiple input signature register.

6. Apparatus for testing a logic device (10) according to any of the above claims characterised in that
the said apparatus is part of a logic device testing machine into which the said logic device (10) is placed.

7. Apparatus for testing a logic device (10) according to claims 1 to 6 characterised in that
the said apparatus is incorporated into the chip on which the said logic device (10) is constructed and is
used for self-testing the said logic device (10).

8. Method for testing a logic device (10) comprising
generating a test pattern;
clocking the test pattern through the said logic device (10);
comparing the results output by the chip with the expected results and;
signalling if a difference is found;
characterised in that
the said method of generating the test pattern includes calculating which device inputs (30) are relevant
for the desired logic gates and
generating a seed, i.e. a pre-calculated initial value for use in a linear feedback shift register (300), wherein
said linear feedback shift register simultaneously generates the device inputs being relevant for said desired logic gates and pseudo-random bit values for the not desired gates.

9. Method for testing a logic device (10) according to claim 8 further characterised in that
said method for comparing the results output by the chip with the expected results and signalling if a difference is found includes compressing the output results and comparing said compressed results with
said compressed expected results.


**Patentansprüche**

1. Vorrichtung zum Überprüfen eines Logikbausteins (10), umfassend
Mittel zum Erzeugen eines Prüfmusters zum Überprüfen des Bauelementes (10), wobei das Bauelement
Bauelementeingänge (30) zum Laden des anfänglichen Prüfmusters in das Bauelement (10) sowie Bauelementausgänge (20) zur Ausgabe der Ergebnisse des Bauelementes (10) besitzt;
Mittel (50) zum Vergleichen der durch das Bauelement ausgegebenen Ergebnisse mit den erwarteten Ergebnissen; und
Mittel zum Signalisieren, ob der Logikbaustein die Prüfung bestanden hat
dadurch gekennzeichnet, daß
die Mittel (40) zum Erzeugen eines Prüfmusters vorgegebene Bitwerte auf vorgegebene
Bauelementeingänge (30) und pseudo-zufällige Bitwerte auf andere Bauelementeingänge (30) legen, wobei das Prüfdatenmuster durch die Erzeugungsmittel (40) gleichzeitig erzeugt wird,
die Mittel (40) zum Erzeugen eines Prüfmusters ein lineares Rückkopplungs-Schieberegister (300) enthalten und daß
das lineare Rückkopplungs-Schieberegister (300) durch die vorberechneten Anfangswerte, d.h. Keime,
gespeist wird.

2. Vorrichtung zum Überprüfen eines Logikbausteins (10) nach Anspruch 1, desweiteren dadurch gekennzeichnet, daß
die Bauelementeingänge (30) miteinander verbunden sind, um einen Schieberegister-Abfragepfad zu bilden, welcher desweiteren mit den Mitteln (40) zum Erzeugen eines Prüfmusters zum Überprüfen des Bauelementes (10) verbunden ist.

3. Vorrichtung zum Überprüfen eines Logikbausteins (10) nach Anspruch 1, desweiteren dadurch gekennzeichnet, daß
die Bauelementausgänge (20) miteinander verbunden sind, um einen Schieberegister-Abfragepfad zu bilden, welcher desweiteren mit den Mitteln (50) zum Vergleichen der durch das Bauelement ausgegebenen Ergebnisse mit den erwarteten Ergebnissen verbunden ist.

4. Vorrichtung zum Überprüfen eines Logikbausteins (10) nach Anspruch 3, desweiteren dadurch gekennzeichnet, daß
die Mittel (50) zum Vergleichen der durch das Bauelement ausgegebenen Ergebnisse mit den erwarteten Ergebnissen Mittel enthalten, mit denen die Daten vor der Durchführung des Vergleichs verdichtet werden.

5. Vorrichtung zum Überprüfen eines Logikbausteins (10) nach Anspruch 4, desweiteren dadurch gekennzeichnet, daß
die Bauelementausgänge (20) und die Mittel (50) zum Vergleichen der durch das Bauelement ausgegebenen Ergebnisse mit den erwarteten Ergebnissen zusammen ein Signalfolge-Register mit mehreren Eingängen bilden.

6. Vorrichtung zum Überprüfen eines Logikbausteins (10) nach einem der vorhergehenden Ansprüche, dadurch gekennzeichnet, daß
die Vorrichtung Teil einer Prüfeinrichtung für Logikbausteine ist, in welcher der Logikbaustein (10) plaziert wird.

7. Vorrichtung zum Überprüfen eines Logikbausteins (10) nach einem der Ansprüche 1 bis 6, dadurch gekennzeichnet, daß
die Vorrichtung auf dem Chip mit integriert ist, auf welchem der Logikbaustein (10) aufgebaut ist und daß sie zum Selbsttest des Logikbausteins (10) verwendet wird.

8. Verfahren zum Überprüfen eines Logikbausteins (10), umfassend
Erzeugen eines Prüfmusters;
Takten des Prüfmusters durch den Logikbaustein (10);
Vergleichen der durch das Chip ausgegebenen Ergebnisse mit den erwarteten Ergebnissen; und
Signalisieren ob eine Differenz aufgetreten ist;
dadurch gekennzeichnet, daß
das Verfahren des Erzeugen des Prüfmusters das Bestimmen der Bauelementeingänge (30) umfaßt, welche für die gewünschten logischen Gatter relevant sind, sowie
das Erzeugen eines Keimes, d.h. eines vorausberechneten Anfangswertes, zur Verwendung in einem linearen Rückkopplungs-Schieberegister (300), wobei das lineare Rückkopplungs-Schieberegister gleichzeitig Bitwerte für die Bauelementeingänge erzeugt, die für die gewünschten logischen Gatter relevant sind sowie pseudo-zufällige Bitwerte für die nicht gewünschten Gatter.

9. Verfahren zum Überprüfen eines Logikbausteins (10) nach Anspruch 8, desweiteren dadurch gekennzeichnet, daß
das Verfahren zum Vergleichen der durch das Chip ausgegebenen Ergebnisse mit den erwarteten Ergebnissen und der darauf beruhenden Anzeige, ob eine Differenz aufgetreten ist, das Verdichten der ausgegebenen Ergebnisse und den Vergleich der verdichteten Ergebnisse mit den verdichteten erwarteten Ergebnissen umfaßt.

## Revendications

1. Appareil pour tester un dispositif logique (10) comprenant :
un moyen (40) de génération d'une configuration de test pour tester le dispositif (10), dans lequel ledit dispositif a des entrées de dispositif (30) pour charger la configuration de test initiale dans le dispositif (10), et des sorties de dispositifs (20) pour délivrer les résultats à partir du dispositif (10),
un moyen (50) pour comparer les résultats de sortie du dispositif avec les résultats attendus, et
un moyen pour signaler si ledit dispositif logique a réussi le test,
caractérisé en ce que :

7

ledit moyen (40) de génération d'une configuration de test produit des valeurs de bit prédéterminées sur certaines desdites entrées de dispositif (30) et des valeurs de bit preudo-aléatoires sur d'autres desdites entrées de dispositif (30), avec la configuration de données de test d'entrée étant générée simultanément par ledit moyen (40) de génération,

ledit moyen (40) de génération d'une configuration de test comprend un registre à décalage à réaction linéaire (300) et

ledit registre à réaction linéaire (300) est alimenté par des valeurs initiales pré calculées telles que des "graines".

2. Appareil pour tester un dispositif logique (10) selon la revendication 1, caractérisé en outre en ce que :

lesdites entrées de dispositif (30) sont connectées ensemble pour former un chemin de balayage de registre à décalage qui est en outre connecté audit moyen (40) de génération d'une configuration de test pour tester le dispositif (10).

3. Appareil pour tester un dispositif logique (10) selon la revendication 1, caractérisé en outre en ce que :

lesdites sorties de dispositif (20) sont connectées ensemble pour former un chemin de balayage de registre à décalage qui est en outre connecté audit moyen (50) pour comparer les résultats de sortie du dispositif avec les résultats attendus.

4. Appareil pour tester un dispositif logique (10) selon la revendication 3, caractérisé en outre en ce que :

le moyen (50) pour comparer les résultats de sortie du dispositif avec les résultats attendus comprend un moyen pour compresser les données avant d'effectuer la comparaison.

5. Appareil pour tester un dispositif logique (10) selon la revendication 4, caractérisé en outre en ce que :

lesdites sorties de dispositif (20) et le moyen (50) pour comparer les résultats de sortie du dispositif avec les résultats attendus forment ensemble un registre de signature à entrées multiples.

6. Appareil pour tester un dispositif logique (10) selon une des revendications précédentes caractérisé en ce que :

ledit appareil est une partie d'une machine de test de dispositif logique dans laquelle ledit dispositif logique (10) est placé.

7. Appareil pour tester un dispositif logique (10) selon une des revendications 1 à 6, caractérisé en ce que :

ledit appareil est incorporé dans une puce sur laquelle ledit dispositif logique (10) est construit et est utilisé pour auto-tester ledit dispositif logique (10).

8. Méthode pour tester un dispositif logique (10) comprenant :

génération d'une configuration de test,

entrée par impulsions d'horloge de la configuration de test dans ledit dispositif logique (10),

comparaison de la sortie des résultats de la puce avec les résultats escomptés, et

avertissement si une différence est trouvée,

caractérisé en ce que :

ladite méthode de génération d'une configuration de test comporte le calcul des entrées de dispositif (30) qui sont significatives pour les portes logiques désirées, et

la génération d'une "graine", c'est à dire d'une valeur initiale pré calculée, pour être utilisée dans un registre à décalage à réaction linéaire (300), dans laquelle ledit registre à décalage à réaction linéaire génère simultanément les entrées de dispositif qui sont significatives pour lesdites portes logiques désirées et des valeurs de bit pseudo-aléatoires pour les portes non désirées.

9. Méthode pour tester un dispositif logique (10) selon la revendication 8, caractérisée en outre en ce que :

ladite méthode de comparaison de la sortie des résultats de la puce avec les résultats escomptés et d'avertissement si une différence est trouvée comprend la compression des résultats de sortie et la comparaison desdits résultats compressés avec lesdits résultats escomptés compressés.

DUT

30a
30b
30c
30d
30e
30f
30g

15

20a
20b
20c
20d
20e
20f
20g

10

40
46
44
42

60

50

FIG. 1
PRIOR ART

CONE 1
100a
100b
100c
100d

OVERLAP
100e
100f
100g
100h

CONE 2
100i
100j
100k
100l
100m
100n

110a
110b
110c
110d
110e
110f
140a

120a
120b
120c

130a
130b
130c
130d
130e
130f
130g
130h
140b

FIG. 2

FIG. 3

START OF SEED CALCULATION

300       310

300a 300b 300c   310a   310c   310e   310g

BACK-SYM   [a]–[b]–[c]   [X]–[1]–[X]–[X]–[0]–[X]–[X]   FAULT-RELEVANT PATTERN

310b   310d   310f

(+) 302

| STEP 1 | b | c | a | 1 | x | x | 0 | x | x | – | |
|---|---|---|---|---|---|---|---|---|---|---|---|
| – 2 | c | a | 1 | x | x | 0 | x | x | – | – | $(b+c) := 1$ |
| – 3 | a | 1 | a+c | x | 0 | x | x | – | – | – | |
| – 4 | 1 | a+c | a+1 | 0 | x | x | – | – | – | – | |
| – 5 | 1 | a+1 | 0 | x | x | – | – | – | – | – | $1+(a+c) := 0$ |
| – 6 | a+1 | 0 | a | x | – | – | – | – | – | – | |
| – 7 | 0 | a | a+1 | – | – | – | – | – | – | – | EMPTY PATTERN |

RESULT OF SEED CALCULATION:

| SEED 1 = | 0 | 0 | 1 | FOR a := 0 | x = NON TEST RELEVANT BITS |
|---|---|---|---|---|---|
| SEED 2 = | 0 | 1 | 0 | a := 1 | 1, 0 = TEST RELEVANT BITS |

FIG. 4A

START OF PATTERN GENERATION (SEED = 0 1 0)

FORW-SYM   [0]–[1]–[0]   [–]–[–]–[–]–[–]–[–]–[–]–[–]   EMPTY PATTERN

(+)

| STEP 1 | 0 | 0 | 1 | 0 | – | – | – | – | – | – | |
|---|---|---|---|---|---|---|---|---|---|---|---|
| – 2 | 1 | 0 | 0 | 1 | 0 | – | – | – | – | – | $(b+c) := 1$ |
| – 3 | 1 | 1 | 0 | 0 | 1 | 0 | – | – | – | – | |
| – 4 | 1 | 1 | 1 | 0 | 0 | 1 | 0 | – | – | – | |
| – 5 | 0 | 1 | 1 | 1 | 0 | 0 | 1 | 0 | – | – | $1+(a+c) := 0$ |
| – 6 | 1 | 0 | 1 | 1 | 1 | 0 | 0 | 1 | 0 | – | |
| – 7 | 0 | 1 | 0 | 1 | 1 | 1 | 0 | 0 | 1 | 0 | |

RESULTING PATTERN:    1   1   1   0   0   1   0

FIG. 4b